(19) Europäisches Patentamt
European Patent Office
Office européen des brevets

(11) Publication number: **0 282 094**
**A2**

(12) # EUROPEAN PATENT APPLICATION

(21) Application number: 88103925.9

(22) Date of filing: 11.03.88

(51) Int. Cl.4: C23C 14/02, B29C 59/14, B05D 3/00

(30) Priority: 12.03.87 US 25122

(43) Date of publication of application: 14.09.88 Bulletin 88/37

(84) Designated Contracting States: BE DE FR GB IT NL

(71) Applicant: HERCULES INCORPORATED
Hercules Plaza
Wilmington Delaware 19894(US)

(72) Inventor: Ho, Filoyd Fong-lok
715 Pheasant Run
West Chester Pennsylvania 19382(US)

(74) Representative: Lederer, Franz, Dr. et al
Van der Werth, Lederer & Riederer
Patentanwälte Lucile-Grahn-Strasse 22
D-8000 München 80(DE)

(54) **Plasma treatment with organic vapos to promote a metal adhesion of polypropylene film.**

(57) Metal adhesion to a polyolefin substrate is improved by subjecting the substrate to a plasma treatment with aliphatic hydrocarbon vapors.

EP 0 282 094 A2

Xerox Copy Centre

# PLASMA TREATMENT WITH ORGANIC VAPORS TO PROMOTE A METAL ADHESION OF POLYPROPYLENE FILM

This invention relates to a method for metallizing a polyolefin film and to the metallized film so produced.

Metallized plastic films are widely used in the packaging industry, which recognizes its outstanding properties, including high strength, good air and moisture barrier characteristics and decorative appeal. However, most of these films, particularly the polyolefins, lack the ability to form strong bonds with the metal coating. One way to create adhesion of the metal is to provide an adhesive interlayer between the film substrate and the metal layer, such as a tacky low molecular weight olefin copolymer applied to the film surface. However, such coating or lamination processes are quite expensive and also add an entirely new layer to the surface of the film, making it much thicker than is otherwise required and sometimes causing crazing in the copolymer layer. The thicker copolymer coatings on the conventional laminates reduce the clarity of the substrate and the thickness of the layers detracts from the aesthetic qualities of the film.

It is also conventional to prepare the film surface for metallization by a corona discharge treatment of its surface, but the adhesion effected by this technique is not particularly good.

It is known to treat a film or other shaped polymer article with an organic plasma to alter its surface properties. For instance, U.S. Patent 4,374,717 teaches that sputtered chromium coatings can be made to adhere to a polyurethane substrate by interposing a layer of plasma-polymerized poly(acrylonitrile). However, that process takes advantage of the relative polarity of both the acrylonitrile and the polyurethane, and is not applicable to the case in which both the substrate and plasma polymerized layer are non-polar materials, such as polyolefins.

A method for preparing polyolefin or other non-polar film surface with a non-polar plasma materials for metallization is disclosed in U.S. Patent 4, 337,279. However, the gas plasma materials disclosed do not include hydrocarbons.

U.S. 4,536,271 teaches application of a plasma polymerized film to a a polyolefin or other substrate, for the purpose of strengthening the film. According to this patent, a thin surface layer that is weak and brittle contributes to failure of of all plastic films by facilitating initiation of fractures. Treatment with certain inorganic or organic plasmas, including hydrocarbon gases, is said to remove this layer, thus strengthening the film. There is no mention of a metal film being applied to the plasma-polymer coating.

There is a need for a method for improving the metallizability of polyolefin films that is more effective than corona treatment, without requiring a laminated interlayer.

According to the invention, a method for metallizing a polyolefin film that includes the step of subjecting a surface of the film to a plasma treatment with organic vapors to enhance its ability to adhere to a metal coating, followed by metallization, is characterized in that the organic vapors are selected from the class consisting of saturated and unsaturated aliphatic hydrocarbons having up to 12 carbon atoms and mixtures thereof.

The preferred organic vapors are vapors of hydrocarbons having 2 to 5 carbon atoms.

Surprisingly, metallized films made by the method according to the invention exhibit metal adhesion in excess of that produced by conventional methods, and it is particularly surprising that good metal-to-polyolefin adhesion is achieved since the treatment (believed to result in the deposition of a thin layer of low molecular weight olefin polymer to the polyolefin surface) does not noticeably alter the other properties of the substrate film. In particular, the treatment does not alter the nonpolar nature of the film; at least a small degree of polarity has in the past been believed to be required for metal adhesion.

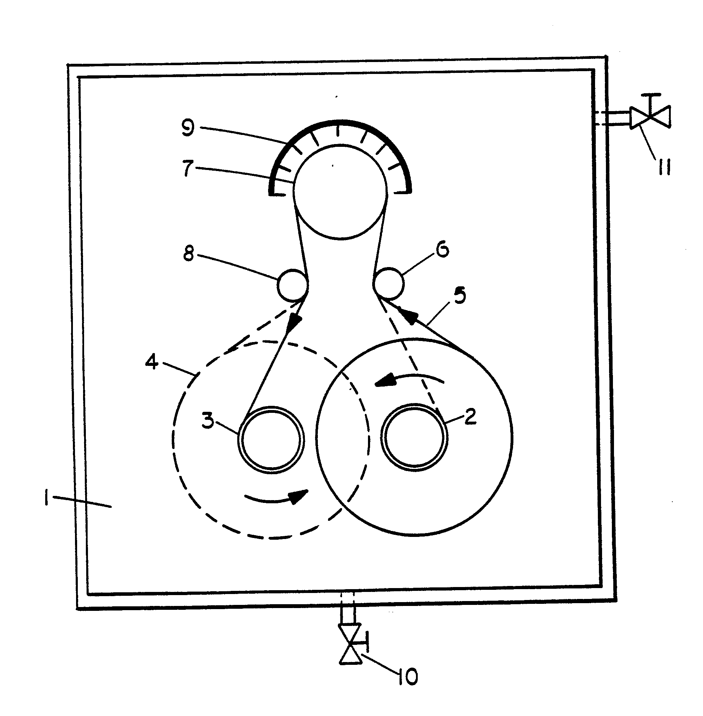

The plasma treatment usable in this invention to prepare metallizable films can be carried out in equipment such as that shown in the attached drawing. The plasma treater shown is a vacuum chamber 1 containing a feed station 2 and a takeup station 3. A roll of film is mounted at feed station 2 and film 5 is fed under idler roll 6, around treating roll 7, under idler roll 8 to take up station 3. Treating roll 7 serves as the ground electrode for plasma generation in conjunction with active electrode 9. The desired environment within the treatment chamber is maintained by drawing a vacuum through vacuum port 10 by a pump or other means, not shown, and admitting the selected treatment gas through vapor inlet 11 from a treatment gas source, not shown. Other structural features such as support members and doors are omitted, for the sake of simplicity.

For treatment with an aliphatic hydrocarbon plasma, a relatively short exposure time at relatively low power is satisfactory. Preferably, a treatment time of about 6 to 30 seconds at about 40 to 80 watts and a vacuum level of about 66.7 Pa to 133.3 Pa (0.5 to 1 torr) is used. A strongly preferred factor in the conditions appears to be the vacuum level, because at pressures above about 133.3 Pa, the life of the reactive species appears to be shortened and thus higher power and longer residence times become necessary. The higher power generates heat that, in combination with the increased residence time, can lead to deterioration of film properties. Increased residence time also decreases the productivity of the equipment.

The increased adhesion between the polyolefin substrate and the metal is attributed to the deposition of a very thin, almost mono-molecular layer of a hydrocarbon polymer having a relatively low degree of polymerization on the surface of the polyolefin. For reasons that are not clearly understood, this very thin layer of hydrocarbon polymer adheres to the polyolefin film extremely tenaciously. In most cases, the adhesion is better than that to the conventional laminated propylene--ethylene copolymer inter-layer between the substrate and the metal coating layer.

In addition to improved adhesion, the metal coated films also exhibit an excellent visual quality. The brightness, image clarity, shiny appearance and overall aesthetic impact are very high.

Plasma treatment to prepare the metallized films of this invention can be carried out with any aliphatic hydrocarbon containing up to 12 carbon atoms and preferably 2 to 5 carbon atoms. Particularly preferred are the unsaturated hydrocarbons such as the alkenes and alkynes such as ethylene, propylene, butene-1, pentene-1, acetylene or methyl acetylene. The most preferred plasma treatment is with ethylene or mixtures of ethylene and propylene.

The most popularly used metal for coating plastic films is aluminum. However, other metals also exhibit excellent adhesion to plasma treated polyolefins, e.g., chromium, gold, silver and copper can be applied to good effect. The metallization can be carried out by sputtering or, more normally, by vacuum deposition. Both techniques are well known and widely used.

The improved adhesion of metal coatings is demonstrated by the examples that follow and the controls included therewith. Samples of vacuum metallized film were laminated at 127°C (260°F) under 138 kPa (20 psi) pressure for 20 seconds to a polypropylene/ethylene--propylene copolymer composite film with the metal in contact with the copolymer. The laminates were pulled at a 180° angle on an Instron$^{R}$tensile tester and the peak adhesion value was recorded for each laminate in grams per centimeter of width. The amount of metal lifted from the plasma treated polyolefin substrate film was also recorded. This test is referred to as the "Laminated Bond Prediction Test."

In a second test method, a strip of adhesive tape (Scotch #610 prescription adhesive tape) was applied securely to the metal surface and pulled in a similar manner. Again peak adhesion value and % metal lift were noted. This test is referred to as the "Peel Test".

A low value for the metal lift parameter indicates that the bond between the plasma treated film and the metal is stronger than the peak adhesion value presented in the table since, in such cases, separation has taken place between the metal and the ethylene--propylene copolymer layer. Conversely the high values for metal lift indicate that separation has taken place between the metal and the plasma treated substrate and thus the peak adhesion values are absolute.

Examples 1 to 9

A series of samples of polypropylene homopolymer film were plasma treated under different conditions of time and power in ethylene gas at different pressures. These were coated with a layer of aluminum about 1 micron thick in a commercial vacuum deposition metallizer. Treating conditions and adhesion values by both the Laminated Bond Prediction Test and the tape test are recorded in Table I.

Table I

| Example No. | Treatment Conditions Watts | Pa | Time (secs) | Laminated Bond Adhesion Peak (g/in) | % Metal Lift | Peel Test Peak (g/in) | % Metal Lift |
|---|---|---|---|---|---|---|---|
| 1 | 40 | 66.7 | 6 | 404 | 0 | 518 | 0 |
| 2 | 40 | 66.7 | 15 | 469 | 0 | 495 | 0 |
| 3 | 40 | 66.7 | 30 | 557 | 0 | 439 | 0 |
| 4 | 40 | 133 | 6 | 552 | 0 | 554 | 0 |
| 5 | 40 | 133 | 15 | 526 | 0 | 547 | 0 |
| Untreated Control | | | | 13 | 100 | 457 | 40 |
| Commercial Product | | | | 172 | 10 | 488 | 0 |
| 6 | 80 | 133 | 6 | 411 | 0 | 541 | 0 |
| 7 | 40 | 267 | 6 | 509 | 0 | 501 | 0 |
| 8 | 40 | 267 | 15 | 422 | 80 | 475 | 0 |
| 9 | 40 | 267 | 30 | 421 | 80 | 468 | 0 |

Examples 10 to 12

Another series of polypropylene homopolymer film samples were plasma treated for different time periods in propylene gas at different pressures. Power level in all cases was 40 watts. These were coated with aluminum (1 micron layer) in a laboratory scale vacuum deposition metallizer. Treating conditions and adhesion values via the Laminated Bond Prediction Test are recorded in Table II.

Table II

| Example No. | Treatment Conditions Pa | Time | Laminated Bond Adhesion Peak (g/in) | % Metal Lift |
|---|---|---|---|---|
| 10 | 66.7 | 6 | 206 | 0 |
| 11 | 66.7 | 3 | 83 | 100 |
| 12 | 66.7 | 1.5 | 41 | 100 |

It is clear from the data that improvements can be affected via the treatment with propylene plasma although for best results longer treatment time is required than in the case of treatment with ethylene gas.

Examples 13 to 16

The procedure of Examples 10 to 12 was repeated with a mixture of ethylene and propylene as the treating gas. Details of these examples are reported in Table III.

Table III

| Example No. | Gas Mix* (%) | Time | Peel Test Peak Value | Peel Test Metal Lift |
|---|---|---|---|---|
| 13 | 23/77 | 6 sec | 174 | 0 |
| 14 | 23/77 | 3 sec | 87 | 100 |
| 15 | 50/50 | 6 sec | 207 | 0 |
| 16 | 50/50 | 3 sec | 106 | 95 |
| Untreated Control | | - | 49 | 93 |
| Commercial Film** | | - | 138 | 10 |

*Ratio of ethylene to propylene.
**Commercial film is metallized homopolymer with a corona-treated ethylene--propylene layer.

## Claims

1. A method for metallizing a polyolefin film that includes the step of subjecting a surface of the film to a plasma treatment with organic vapors to enhance its ability to adhere to a metal coating, followed by metallization, characterized in that the organic vapors are selected from the class consisting of saturated and unsaturated aliphatic hydrocarbons having up to 12 carbon atoms and mixtures thereof.

2. A method for metallizing a polyolefin film as claimed in claim 1 further characterized in that the organic vapors are vapors of hydrocarbons having 2 to 5 carbon atoms..

3. A method for metallizing a polyolefin film as claimed in claim 2 further characterized in that organic vapors are vapors of ethylene, propylene, or a mixture of ethylene and propylene.

4. A method for metallizing a polyolefin film as claimed in any of the preceeding claims, further characterized in that the plasma treatment time is about 6 to 30 seconds at about 40 to 80 watts.

5. A method for metallizing a polyolefin film as claimed in any of the preceeding claims, further characterized in that the plasma treatment is carried out at a vacuum level not over about 133.3 Pa.

6. A method for metallizing a polyolefin film as claimed in claim 5, further characterized in that the plasma treatment is carried out at a vacuum level of above 66.7 Pa.

7. A method for metallizing a polyolefin film as claimed in claim 1, further characterized in that the polyolefin substrate is a propylene polymer.

9
7
8
6
5
4
3
2
1
11
10

HERCULES INCORPORATED
HO Case No. 1